# EUROPÄISCHE PATENTSCHRIFT

(11) **EP 2 181 068 B1**
(45) Veröffentlichungstag und Bekanntmachung des Hinweises auf die Patenterteilung: **30.03.2011**
(21) Anmeldenummer: 08787021.8
(22) Anmeldetag: 08.08.2008
(51) Int. Cl.: C01B 33/00, H01L 21/00

(54) **VERFAHREN ZUM REINIGEN VON POLYKRISTALLINEM SILICIUM**
METHOD FOR PURIFYING POLYCRYSTALLINE SILICON
PROCÉDÉ DE PURIFICATION DE SILICIUM CRISTALLIN

(30) Priorität: 29.08.2007 DE 102007040851
(43) Veröffentlichungstag der Anmeldung: 05.05.2010
(73) Patentinhaber: Wacker Chemie AG, 81737 München (DE)
(72) Erfinder: WOCHNER, Hanns, 84489 Burghausen (DE); GOSSMANN, Christian, 84547 Emmerting (DE); LINDNER, Herbert, A-5121 Ostermiething (AT)
(74) Vertreter: Fränkel, Robert
(86) Internationale Anmeldenummer: PCT/EP2008/060425
(87) Internationale Veröffentlichungsnummer: WO 2009/027200

(56) Entgegenhaltungen:
- EP-A- 0 905 796
- EP-A- 1 876 143
- EP-A- 1 894 887
- DE-A1- 3 317 286
- DE-A1- 19 529 518
- DE-A1- 19 817 486
- US-A- 5 846 921
- US-B1- 6 369 008

## Beschreibung

Die Erfindung betrifft ein Verfahren zum Reinigen von polykristallinem Silicium mit einer verbesserten Strömung der Reinigungslösungen im Prozess.

Für die Herstellung von Solarzellen oder elektronischen Bauelementen, wie beispielsweise Speicherelementen oder Mikroprozessoren, wird hochreines Halbleitermaterial benötigt. Die gezielt eingebrachten Dotierstoffe sind die einzigen Verunreinigungen, die ein derartiges Material im günstigsten Fall aufweisen sollte. Man ist daher bestrebt, die Konzentrationen schädlicher Verunreinigungen so niedrig wie möglich zu halten. Häufig wird beobachtet, dass bereits hochrein hergestelltes Halbleitermaterial im Verlauf der weiteren Verarbeitung zu den Zielprodukten erneut kontaminiert wird. So werden immer wieder aufwändige Reinigungsschritte notwendig, um die ursprüngliche Reinheit zurückzuerhalten.

Insbesondere ist die Kontamination durch Metallatome als kritisch anzusehen, da diese die elektrischen Eigenschaften des Halbleitermaterials in schädlicher Weise verändern können. Wird das zu zerkleinernde Halbleitermaterial, wie bisher überwiegend üblich, mit mechanischen Werkzeugen, wie beispielsweise stählernen Brechern, zerkleinert, so müssen die Bruchstücke vor dem Aufschmelzen einer Oberflächenreinigung unterzogen werden.

Zur Entfernung der Verunreinigungen wird beispielsweise die Oberfläche des mechanisch bearbeiteten polykristallinen Siliciums mit einer Mischung aus Salpetersäure und Fluorwasserstoffsäure geätzt. Bei dem Prozess werden in der Vorreinigung die Metallpartikel von der Säuremischung stark angegriffen. Zurück bleiben Metallcarbidrückstände, die in der HF/HNO₃-Hauptreinigung weitestgehend aufgelöst werden.

Der Polysiliciumbruch wird dabei üblicherweise bei der Reinigung in Körben oder Schalen nacheinander in verschiedene Reinigungslösungen getaucht.

EP 0905796 beschreibt einen Reinigungsprozess bestehen aus einer Vorreinigung mittels einer Mischung bestehend aus HF/HCl/H₂O₂ einer Hauptreinigung mittels HF/HNO₃ und einer anschließenden Hydrophilierung der Siliciumoberfläche durch HCl/H₂O₂. Beim Reinigungsprozess erfolgt das Spülen in Durchfluss- oder Dumpbecken. Der Siliciumbruch wird dabei in einer Reinigungsmaschine auf der Basis einer Auf- und Abbewegung gereinigt. Zusätzlich kann die mit Polysiliciumbruch beladene Schale bei der Hub/Senk-Bewegung auch vollständig aus der Flüssigkeit herausfahren, damit die Reinigungslösung vollständig vom Siliciumbruch abfließen kann. Als Nachteil erweist sich, dass im laufenden Prozess an den Siliciumbruchstücken Flecken mit grauem Aussehen gefunden werden. Untersuchungen haben gezeigt, dass die grauen Flecken stets an den Kontaktstellen zwischen einzelnen Polybruchstücken oder zwischen Polybruchstücken und der Prozessschalenwand auftreten. Die Ursache ist eine zu geringe Strömung in den Totwassergebieten zwischen den einzelnen Polybruchstücken. Ein weiterer Nachteil bei dem beschriebenen Verfahren ist die unerwünschte Restsäurekonzentration an den Bruchstücken. Trotz massivem Erhöhen der Durchflussmenge bis zu einem kompletten Flüssigkeitsaustausch im Becken unter einer Sekunde, konnten mit Ionenchromatographie und IC-Messungen auf dem gereinigten Polybruch immer geringste Säurespuren im pptw-Bereich nachgewiesen werden.

Aus dem Stand der Technik ist auch bekannt, Polysiliciumstäbe (FZ-Stäbe) und Dünnstäbe in Trommelanlagen zu ätzen. Versuche an derartigen Anlagen mit Polybruch zeigen zwar, dass bei Umdrehungszahlen größer ½ Umdrehung pro Minute keine Überlagerungsflecken entstehen, aber der scharfkantige Polysiliciumbruch erzeugt bereits bei niedriger Drehzahl der Trommel sichtbaren Abrieb des Trommelmaterials. Dieser Abrieb ist für eine spätere Anwendung des Polysiliciumbruchs als Halbleitermaterial nicht akzeptabel.

US 2006/0042539 beschreibt eine Anlage, bei der die Horde in dem Behälter wahrend der Behandlungsdauer in eine geregelte translatorische Bewegung in seitlicher Richtung versetzt wird. Die translatorische Bewegung führt aber zu gleichen Resultaten wie die in EP 0905 796 beschriebe Hub/Senkbewegung. Das Problem des Totwassergebietes an den Kontaktstellen kann auch mit einer derartigen Anlage nicht gelöst werden.

DE 69905538 beschreibt eine Zentrifugenanlage zum Reinigen von kleinen Teilen. Dabei wird eine Umlagerung der Teile durch ständigen Wechsel zwischen Zentrifugalkraft und Gravitation erreicht. Bei hoher Drehzahl wirkt die Zentrifugalkraft und bei niedriger Drehzahl die Gravitation. Durch diesen Wechsel werden die Teile ständig umgelagert. Nachteilig ist auch hier, dass durch die Relativbewegung mit dem Gefäß ein Abrieb entsteht, der für halbleitergerechten Polysiliciumbruch nicht akzeptabel ist.

DE 33 17 286 offenbart ein Verfahren zur Säurereinigung von Siliciumbruchstücken, bei dem Silicium als stationäre Phase vorlegt und eine oder mehrere mobile saure Phasen durch Druckeinwirkung zum Durchströmen des Siliciums gebracht werden. Beispiel 1 beschreibt ein Verfahren zur Bearbeitung von Rohsilicium dadurch gekennzeichnet, daß das Silicium als stationäre Phase in Kammern, die einen Durchmesser von 470 x 470 mm² aufweisen, durch einer mobile saure Phase mit einer Durchsatzrate von 5 m³/h behandelt wird. Damit kann man eine Geschwindigkeit der saure Phase von 6,3 mm/s in den leeren Kammern errechnen.

Alle aus dem Stand der Technik bekannten Lösungen führen zu keinen brauchbaren Ergebnissen. Wenn die Ätzvorrichtungen mit einer Umlagerung des Polysiliciumbruchs verbunden sind, ist immer mit einem nicht akzeptierbaren Abrieb der Behältnisse zu rechnen. Anwendungen, wie sie aus der Reinigung und Ätzung der Halbleiterscheiben bekannt sind, sind aufgrund der unterschiedlichen Geometrien von Polysiliciumbruch und Wafern nicht übertragbar.

Es bestand daher die Aufgabe, ein verbessertes Verfahren zur Reinigung von Polysiliciumbruch bereitzustellen, bei dem keine Totwassergebiete auftreten und damit die Fleckenbildung am Polysiliciumbruch verhindert wird. Gleichzeitig soll die Spülleistung so hoch sein, dass keine Säurereste mehr am Polysiliciumbruch nachzuweisen sind.

Überraschenderweise wurde gefunden, dass beim Ätzen von Polysilicium mit Strömungsgeschwindigkeiten auf die Polysiliciumoberfläche von größer 100 mm pro Sekunde, die aus mehr als zwei verschiedenen Richtungen auf die Oberfläche des Polysiliciumbruchs auftrifft, der Abtrag bei gleicher Säurekonzentration gesteigert werden kann und gleichzeitig das Entstehen von Totwassergebieten und damit die Ursache für die Flecken beseitigt werden konnte.

Gegenstand der Erfindung ist ein Verfahren zur Reinigung von Polysiliciumbruch, dadurch gekennzeichnet, dass die Strömung der Reinigungsflüssigkeit in mindestens einem der Prozessschritte eine Strömungsgeschwindigkeit von größer 100 mm/sec aufweist, die aus mehr als zwei verschiedenen Richtungen auf die Oberfläche des Polysiliciumbruchs trifft.

Mit dem erfindungsgemäßen Verfahren konnte der Stoffaustausch während der Verweilzeiten des Polysiliciumbruchs in den Reinigungsbädern so verbessert werden, dass keine Totwassergebiete im Schüttgut entstehen und damit keine Flecken mehr am Polysiliciumbruch entstehen. Der Ätzabtrag konnte bei gleicher Säurekonzentration deutlich gesteigert werden.

Zur Erzeugung einer Strömung von größer 100 mm/sec während des Reinigungsprozesses, die aus mehr als zwei verschiedenen Richtungen auf die Oberfläche des Polysiliciumbruchs auftrifft, sind verschiedene Anordnungen möglich.

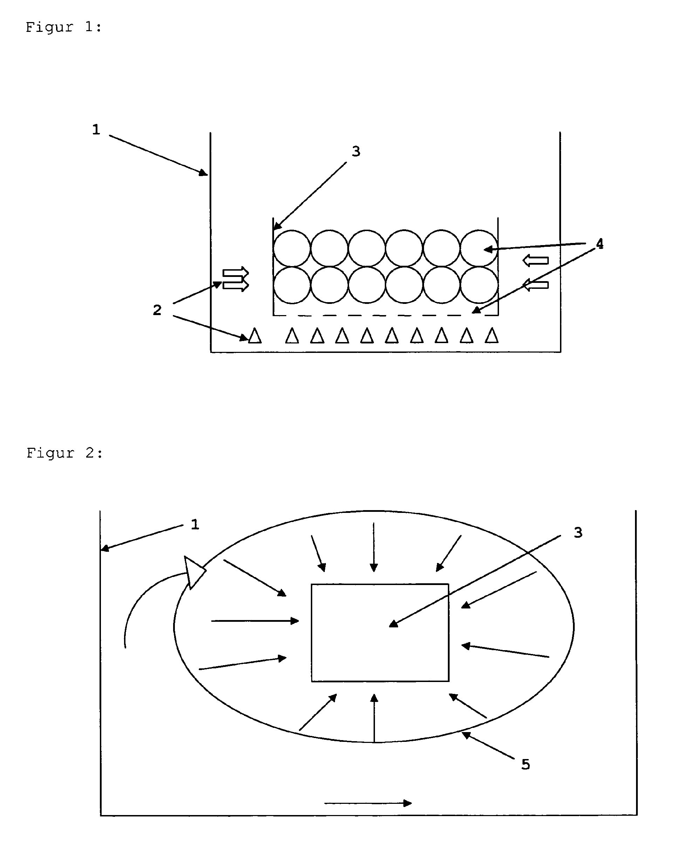

In einer Ausführungsform des erfindungsgemäßen Verfahrens wird die Verbesserung der Strömungsverhältnisse zwischen den Kontaktstellen der einzelnen Bruchstücke durch nicht gerichtetes, diffuses Einblasen der Reinigungsflüssigkeit in das Ätzbecken, durch wechselseitig tätige Düsen erzielt (Figur 1). Im Ätzbecken (1) befinden sich dabei mehrere Düsen zum Einströmen der Reinigungsflüssigkeit (2), die am Boden und an den Seitenwänden angebracht sind. Das Schüttgut hängt im Ätzbecken in einer Schale (3) mit Öffnungen (4) an den Seiten und am Boden. Bevorzugt werden dabei Düsenzahlen zwischen 1 und 1000. Besonders bevorzugt werden 10 bis 100 Düsen. Aus diesen Düsen erfolgt der Austritt der Ätzmischung mit einer Geschwindigkeit größer als 100 mm/sec. Bevorzugt werden Strömungsgeschwindigkeiten von 100 bis 200 mm/sec, besonders bevorzugt 150 mm/sec.

Die Düsen können zeitversetzt im Wechseltakt mit einer zeitlichen Verzögerung von 0,1 bis 60 sec für eine Zeit von 0,1 bis 60 sec geöffnet werden. Bevorzugt werden zeitliche Verzögerungen von 1 bis 4 sec und eine einstellbare Öffnungszeit von 0,2 bis 1 sec. Die Düsen haben eine Öffnung von 0,01 bis 5 mm. Bevorzugt wird eine Öffnung von 0,5 bis 2 mm verwendet. Besonders bevorzugt werden 50 Düsen mit einem Austrittsdurchmesser von 1 mm. Durch die wechselseitige Anströmung der einzelnen Bruchstücke wird das Entstehen von Totwassergebieten an den Kontaktstellen zwischen den Polybruchstücken verhindert. An allen Stellen im Schüttgut herrscht eine gleichmäßige Strömungsgeschwindigkeit vor.

In einer weiteren Ausführungsform des erfindungsgemäßen Verfahrens wird die Verbesserung der Strömungsverhältnisse zwischen den Kontaktstellen der einzelnen Bruchstücke durch einen oder mehrere bewegte Düsenkränze im Ätzbecken erzeugt (Figur 2). Dabei werden bewegte, sich drehende, Düsenkränze (5) um die Prozessschale (3) angeordnet. Durch Variation der Austrittsgeschwindigkeit aus den Düsen wird dabei im Ätzbecken eine Anströmung größer 100 mm/sec aus verschiedenen Richtungen auf die Bruchstücke erhalten. Die Düsenkränze enthalten bevorzugt zwischen 5 bis 500 Düsen mit einer Öffnung von 0,01 bis 5 mm.

Die Düsen können auch, wie in der oben bereits beschriebenen Ausführungsform, zusätzlich noch mit einer zeitlichen Verzögerung und einer einstellbaren Öffnungszeit betätigt werden. Bevorzugt werden hier ebenfalls die Zeiten, wie in der ersten Ausführungsform beschrieben. Bevorzugt werden 10 bis 100 Düsen mit einer Öffnung von 0,01 bis 5 mm. Bevorzugt wird eine Öffnung von 0,5 bis 2 mm verwendet. Besonders bevorzugt werden 50 Düsen mit einem Austrittsdurchmesser von 1 mm.

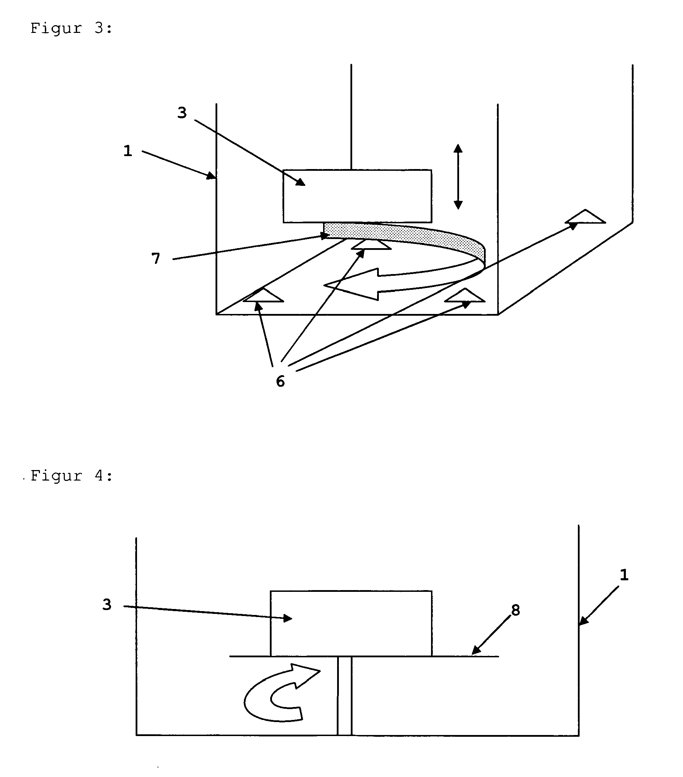

In einer weiteren Ausführungsform des erfindungsgemäßen Verfahrens wird die Verbesserung der Strömungsverhältnisse zwischen den Kontaktstellen der einzelnen Bruchstücke durch Ein so genanntes "Prinzip der rotierenden Säure" erzeugt (Figur 3).

Am Boden des Ätzbeckens (1) sind dabei mehrere Düsen (6) mit einer Öffnung von 0,01 bis 5 mm in der Weise angeordnet, dass die Säuremischung in eine Rotationsbewegung versetzt wird. Aus den Düsen erfolgt der Austritt der Ätzmischung mit einer Geschwindigkeit von größer 100 mm/sec. Bevorzugt werden Düsen mit einer Öffnung von 0,5 bis 4 mm, besonders bevorzugt von 1 mm und einer Austrittgeschwindigkeit von 100 mm/sec. In der rotierenden Säure (7) kann die Prozessschale (3) ruhen oder mittels einer zusätzlichen Hub-/Senkbewegung bewegt werden. Bevorzugt wird eine zusätzliche Hub-/Senkbewegung, bei der die Prozessschale bei jeder Hub-/Senkbewegung vollständig aus der Flüssigkeit ein- und austritt.

In einer weiteren Ausführungsform des erfindungsgemäßen Verfahrens wird die Verbesserung der Strömungsverhältnisse zwischen den Kontaktstellen der einzelnen Bruchstücke durch die Anwendung eines sich in horizontaler Ebene rotierenden Drehtellers, auf dem sich die Prozessschale befindet (Figur 4), erzeugt.

Die Rotationsbewegung der Prozessschale (3) auf dem Drehteller (8) beträgt dabei bevorzugt zwischen 1 und 500 Umdrehungen pro Minute. Damit wird im Ätzbecken (1) eine ausreichende Anströmung des Polysiliciumbruchs aus verschiedenen Richtungen erzeugt. Besonders bevorzugt wird eine Drehzahl von 20 bis 100 Umdrehungen pro Minute, ganz besonders bevorzugt 50 Umdrehungen pro Minute. Durch die Einstellung der geeigneten Drehzahl der horizontalen Drehbewegung, wird eine Anströmung aus verschiedenen Richtungen auf die Oberfläche der einzelnen Siliciumbruchstücke mit einer Geschwindigkeit von größer 100 mm/sec erzeugt.

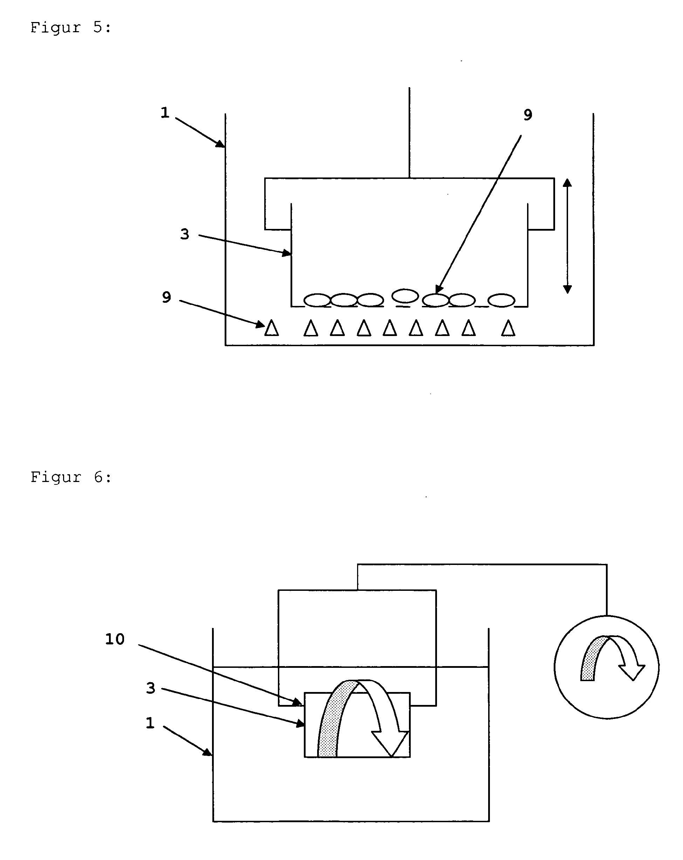

In einer weiteren Ausführungsform des erfindungsgemäßen Verfahrens kann die Verbesserung der Strömungsverhältnisse zwischen den Kontaktstellen der einzelnen Bruchstücke auch durch zusätzliches, nicht gerichtetes Einblasen von Luft durch den Schalenboden erreicht werden (Figur 5). Durch diese Maßnahme wird eine Erhöhung der Strömungsgeschwindigkeit an den kritischen Kontaktstellen von größer 100 mm/sec erreicht. Bevorzugt werden am Boden des Ätzbeckens (1) 5 bis 100 Düsen (9) angebracht, aus denen die Luft von unten in Richtung der Prozessschale (3) mit dem Polysiliciumbruch (9) in das Ätzbecken eingeblasen wird. Die Größe der Öffnung der Düsenausgänge beträgt bevorzugt 0,01 bis 5 mm. Der Druck der eingeblasenen Luft beträgt bevorzugt zwischen 0,1 bis 200 bar. Besonders bevorzugt werden 20 bis 100 Düsen mit einer Öffnung von 0,1 bis 1 mm Düsenöffnung.

Die Düsen können, wie in den oben beschriebenen Ausführungsformen, zusätzlich noch mit einer zeitlichen Verzögerung und einer einstellbaren Öffnungszeit betätigt werden. Bevorzugt werden die zeitlichen Verzögerungen und die Öffnungszeiten analog den bereits beschriebenen Ausführungsformen. Durch die zusätzliche Verwirbelung, die durch die eingeblasene Luft in die Reinigungslösung erzeugt wird, kann die Säure ungehindert an allen Kontaktstellen zwischen den Polybruchstücken hindurchfließen.

In einer weiteren Ausführungsform des erfindungsgemäßen Verfahrens wird die Verbesserung der Strömungsverhältnisse zwischen den Kontaktstellen der einzelnen Bruchstücke durch eine sich auf einer vertikalen Achse bewegenden Prozessschale (Figur 6) erzeugt.

Die verwendete Prozessschale (3) ist dazu mit seitlichen Löchern (10) ausgerüstet und wird auf einer vertikalen Kreisbahn durch das Ätzbad geführt. Bevorzugt wird dabei eine Kreisbewegung mit einer Frequenz von 1 bis 200 Umdrehungen pro Minute, besonders bevorzugt wird eine Drehzahl von 5 bis 50 Umdrehungen pro Minute, ganz bevorzugt 10 Umdrehungen pro Minute.

Die Kreisbewegung kann innerhalb der Reinigungsflüssigkeit durchgeführt werden oder auch partiell außerhalb der Reinigungsflüssigkeit. Wird eine Kreisbewegung ausgeführt, bei der ein Ein- und Austauchen in die Flüssigkeit stattfindet, kann die Prozessschale dabei ganz oder teilweise aus der Flüssigkeit herausgefahren werden.

Bevorzugt wird eine Kreisbewegung mit Ein- und Austauchen in der Flüssigkeit, wobei ein ständiges Befüllen und Entleeren der Prozessschale stattfindet.

In einer weiteren Ausführungsform des erfindungsgemäßen Verfahrens wird die Verbesserung der Strömungsverhältnisse zwischen den Kontaktstellen der einzelnen Bruchstücke durch das Anlegen von Ultraschall erzeugt. Überraschenderweise konnte gezeigt werden, dass durch das Anlegen von Ultraschall mit einem Arbeitsfrequenzbereich von 10 kHz bis 5 GHz der Angriff auf Silicium in der HF/HNO3-Ätze überraschenderweise deutlich erhöht wird. Bevorzugt wird eine Arbeitsfrequenz von 500 kHz bis 2 GHz. Besonders bevorzugt wird eine Arbeitsfrequenz von 1 GHz. Der Ultraschall hat im Schüttgut eine positive Wirkung auf den Ätzvorgang und auf das Auflösen der Metallpartikel. Die Metalloberflächenwerte können signifikant abgesenkt werden und es konnte damit dieselbe Wirkung erhalten werden, wie bei Strömungsgeschwindigkeiten größer 100 mm/sec. Überraschenderweise können mit der Ultraschalltechnik sowohl in den Säure- als auch in den Spülbädern aus Rissen von Polybruch Säurereste besser herausgespült werden.

Durch alle beschriebenen erfindungsgemäßen Anordnungen konnte erreicht werden, dass die Reinigungsflüssigkeit aus mehr als 2 verschiedenen Richtungen mit einer Geschwindigkeit größer als 100 mm/sec das Polysiliciumschüttgut durchströmt. Die Kontaktstellen im Schüttgut werden dabei gleichmäßig durchströmt und am gereinigten Polysilicium treten weder Flecken an den Bruchstücken auf, noch können nennenswerte Säurereste nachgewiesen werden.

Anhand der folgenden Beispiele soll die Erfindung näher erläutert werden.

### Durchführung der CE-Messungen / Ionenchromatographiemessungen:

5 kg Polybruch wurden in einem geschlossenen Kunststoffbehälter mit 100 ml Reinstwasser befüllt. Der verschlossene Behälter bleibt eine Woche lang stehen. Anschließend wurde mit einer Ionenchromatographie-Messung oder einer Kapillarelektrophorese der Fluorid-, Nitrat-, Nitrit- und Chloridgehalt gemessen.

### Durchführung der Metallanalysen am gereinigten Polybruch:

In einem Teflontrichter wurden 100 g schweres Polysilicium mit 40 ml HF/HNO3 1:4 abgespritzt. Die Ätzsäure wurde in einem Teflonbecher aufgefangen. Anschließend wurde die Säure abgedampft und der Rückstand in 5 ml Wasser aufgenommen. Der Metallgehalt der wässrigen Lösung wird am ICP-AES (Induktivgekoppeltes Ionenplasma-Atomemissionsspektroskop der Firma Spectro) gemessen. Aus den gemessenen Werten wird der Metallgehalt der Polysiliciumoberfläche berechnet. Die Angaben erfolgten in pptw.

### Vergleichsbeispiel 1: (Einfluss der Strömung auf den Ätzabtrag und Flecken bei einer Hub-/Senkanlage)

Anhand des in EP 0905 796 beschriebenen Hub-/Senk-Verfahrens zum Reinigen von Polybruch wurde der Einfluss der Strömung im Ätzbecken auf den Ätzabtrag und die Flecken untersucht. Die Strömung auf den Polysiliciumbruch wird bei diesem Verfahren durch eine Auf- und Abbewegung der Prozessschale, die mit Polybruch befüllt ist, erzeugt. Die Umwälzung der Säure geschieht in vertikaler Richtung von unten nach oben.

Der folgenden Tabelle 1 kann der Zusammenhang zwischen der Strömung auf die Polyoberfläche, die aus der Auf- und Abbewegung und der Umwälzung resultiert, und dem Ätzabtrag entnommen werden.

Verwendete Reinigungslösung: 5 Gew.-% HF, 55 Ges.-% HNO₃ und 8 Gew.-% H₂SiF₆; Temperatur im Ätzbad 20°C.

**Tabelle 1:**

| Summe der Strömung auf den Polybruch | Siliciumabtrag |
|---|---|
| 0 mm/sec | 0,6 µm/Min. |
| 10 mm/sec | 2,5 µm/Min. |
| 30 mm/sec | 4,3 µm/Min. |
| 50 mm/sec | 5,5 µm/Min. |
| 70 mm/sec | 5,7 µm/Min. |
| 90 mm/sec | 5,8 µm/Min. |
| 100 mm/sec | 5,8 µm/Min. |

Verwendete Reinigungslösung: 5 Gew.-% HF, 55 Gew.-% HNO₃ und 8 Gew.-% H₂SiF₆; Temperatur im Ätzbad 20°C.

Die Tabelle zeigt, dass sich mit einer Hub-/Senkanlage bei einer Strömung von größer 50 mm/sec auf die Polysiliciumoberfläche der Ätzabtrag nicht mehr merklich erhöht. Mit einer Hub-/Senk-Anlage sind großtechnisch für Produktionsanlagen Strömungsgeschwindigkeiten bis maximal 100 mm/sec mit einem vertretbaren finanziellen Aufwand möglich. Bei Strömungsgeschwindigkeiten bis zu 100 mm/sec werden jedoch graue Flecken durch den zu geringen Stoffaustausch in den Totwassergebieten erhalten.

Die gereinigten Polybruchstücke enthielten aus Ionenchromatographie oder CE-Messungen folgende Analysenwerte: Fluorid 2 pptw, Nitrat 5 pptw, Nitrit 0,1 pptw und Chlorid 3 pptw

### Beispiel 1: (Strömung durch wechselseitige Düsen)

Ein Polysiliciumstab wurde mittels einer Vorrichtung aus einem Zerkleinerungswerkzeug und einer Siebvorrichtung zerkleinert und klassiert. 5 kg Polybruch wurden in einer Prozessschale mit folgendem dreistufigen Reinigungsprozess analog EP 0 905 796 behandelt. Zur Vorreinigung wurde der Polysiliciumbruch 20 Minuten in einer Mischung aus HF/HCl/H₂O₂ bei einer Temperatur von 25°C gereinigt. Bei der anschließenden Hauptreinigung wurde der Polysiliciumbruch 5 Minuten bei 8°C in einer Mischung von HF/HNO₃ geätzt. Danach wurde 5 Minuten in Reinstwasser mit 18 Megaohm bei einer Temperatur von 22°C gespült. Abschließend wurde 5 Minuten in einer Mischung aus HCl/H₂O₂ bei einer Temperatur von 22°C hydrophiliert und 60 Minuten mit Reinstluft der Klasse 100 bei 80°C getrocknet.

In der Vorreinigung, in den Spülbädern und der Hydrophilierung führte der Korb mit einer Einwaage von 5 kg eine Auf- und Ab-Bewegung mit dem Polybruch mit einer Hubfrequenz von 5 Hüben pro Minute durch.

Die Hauptreinigung fand in einem Ätzbad mit 500 l Säure statt, in dem sich 50 Düsen befanden. Aus den Düsen erfolgte der Austritt der HF/HNO₃ -Ätzmischung mit einer Geschwindigkeit von 150 mm/sec. Die Düsen wurden zeitversetzt im Wechseltakt mit einer zeitlichen Verzögerung von 2 sec für eine Zeit von 0,5 sec geöffnet. Die Düsen hatten eine Öffnung von 1 mm. Durch die wechselseitige Anströmung der einzelnen Bruchstücke wurde das Entstehen von Totwassergebieten an den Kontaktstellen zwischen den Polybruchstücken verhindert. An allen Stellen im Schüttgut herrscht eine gleichmäßige Strömungsgeschwindigkeit.

Nach der Hydrophilierung und Trocknung wurde ein Polybruch ohne Flecken auf dessen glänzenden Flächen erhalten.

### Beispiel 2: (Ätzen in rotierender Säure)

Es wurde analog dem Beispiel 1 vorgegangen.

Abweichend davon wurde bei der Hauptreinigung die Prozessschale in einer 500 Liter HF/HNO₃ -Ätzmischung im Säurebecken mit einer Hub-/Senkbewegung mit einer Frequenz von 5 Hüben pro Minute bewegt. Am Boden des Beckens waren 4 Düsen mit einer Austrittsöffnung von 1 mm angebracht. Aus diesen trat die Säure mit einer Geschwindigkeit von 150 mm/sec aus. Bei der Hub-/Senkbewegung trat die Schale ständig vollständig aus der Säure aus und wieder ein. Die Säure hatte eine Temperatur von 8°C. Durch die rotierende Säure wurde im Schüttgut eine gleichmäßige Durchströmung an allen Stellen erreicht. Hierdurch konnten Totwassergebiete an den Kontaktstellen zwischen den Polybruchstücken verhindert werden.

Nach der Hydrophilierung und Trocknung wurde ein Polybruch ohne Flecken auf dessen glänzenden Flächen erhalten.

### Beispiel 3: (horizontaler Drehteller)

Es wurde analog dem Beispiel 1 vorgegangen.

Abweichend davon wurde bei der Hauptreinigung die Prozessschale in einer 500 Liter HF/HNO₃ -Ätzmischung im Säurebecken auf einem Drehteller in horizontaler Richtung rotiert. Die Drehbewegung betrug 50 Umdrehungen pro Minute. Durch die horizontale Drehbewegung mit der angegebenen Drehzahl wurde eine Anströmung aus verschiedenen Richtungen an die Oberfläche der einzelnen Bruchstücke von 150 mm/sec erzeugt. Hierdurch konnten Totwassergebiete an den Kontaktstellen zwischen den Polybruchstücken verhindert werden.

Nach der Hydrophilierung und Trocknung wurde ein Polybruch ohne Flecken auf dessen glänzenden Flächen erhalten.

### Beispiel 4: (diffuses Einblasen von Luft)

Es wurde analog dem Beispiel 1 vorgegangen.

Abweichend davon wurde bei der Hauptreinigung die Prozessschale in einer 500 Liter HF/HNO₃ -Ätzmischung im Säurebecken mit einer Hub-/Senkbewegung mit einer Frequenz von 5 Hüben pro Minute bewegt. Am Boden des Beckens waren zusätzlich 50 Düsen mit einer Öffnung von 0,1 mm angebracht. Durch diese Düsen wurde durch den Schalenboden zusätzlich Luft eingeblasen. Dadurch konnte eine Erhöhung der Strömungsgeschwindigkeit an den Kontaktstellen erreicht werden. Die Strömungsgeschwindigkeit betrug 150 mm/sec. Die Düsen wurden mit einer zeitlichen Verzögerung von 2 sec für 0,5 sec. geöffnet. Durch die zusätzliche Verwirbelung, die durch die einblasende Luft erzeugt wird, kann die Säure ungehindert an allen Kontaktstellen zwischen den Polybruchstücken hindurchfließen. Nach der Hydrophilierung und Trocknung wurde ein Polybruch ohne Flecken auf dessen glänzenden Flächen erhalten.

### Beispiel 5: (vertikale Bewegung der Prozessschale)

Es wurde analog dem Beispiel 1 vorgegangen.

Abweichend davon wurde bei der Hauptreinigung die Prozessschale in einer 500 Liter HF/HNO₃ -Ätzmischung mit einer vertikalen Kreisbewegung durch das Säurebecken bewegt. Die Frequenz der Kreisbewegung betrug 10 Umdrehungen pro Minute. Hierdurch strömt die Säure mit einer Geschwindigkeit von 150 mm/sec von allen Richtungen an die Polyoberflächen. Die Badtemperatur betrug 8°C und wurde ständig umgewälzt. Die Zeit im Ätzbad betrug 5 Minuten. Bei der Kreisbewegung wurde die Schale bei jedem Zyklus vollständig in die Flüssigkeit eingetaucht und vollständig herausgenommen. Durch die Kreisbewegung wird eine gleichmäßige Durchströmung des Schüttgutes erreicht, die das Entstehen von Totwassergebieten an den Kontaktstellen des Polybruchs verhindert.

Nach der Hydrophilierung und Trocknung wurde ein Polybruch ohne Flecken auf dessen glänzenden Flächen erhalten.

### Beispiel 6: (Strömung durch Ultraschall)

Ein Polysiliciumstab wurde mittels einer Vorrichtung aus einem Zerkleinerungswerkzeug und einer Siebvorrichtung zerkleinert und klassiert. 5 kg Polybruch wurden in einer Prozessschale mit folgendem dreistufigen Reinigungsprozess analog EP 0 905 796 behandelt. Zur Vorreinigung wurde der Polysiliciumbruch 20 Minuten in einer Mischung aus HF/HCl/H₂O₂ bei einer Temperatur von 25°C gereinigt. Bei der anschließenden Hauptreinigung wurde der Polysiliciumbruch 5 Minuten bei 8°C in einer Mischung von HF/HNO₃ geätzt. Danach wurde 5 Minuten in Reinstwasser mit 18 Megaohm bei einer Temperatur von 22°C Grad gespült. Abschließend wurde 5 Minuten in einer Mischung aus HCl/H₂O₂ bei einer Temperatur von 22°C hydrophiliert und 60 Minuten mit Reinstluft der Klasse 100 bei 80°C getrocknet.

In der Vorreinigung, in der HF/HNO₃-Hauptreinigung, in den Spülbädern und der Hydrophilierung führte der mit 5 kg Polybruch befüllte Korb eine Auf- und Ab-Bewegung mit einer Hubfrequenz von 5 Hüben pro Minute durch. Zusätzlich war in allen Reinigungs- und Spülschritten ein Ultraschallgeber mit einer Arbeitsfrequenz von 1 GHZ eingebaut.

Nach Prozessabschluss wurde ein im Vergleich zu einem Prozess ohne Ultraschallbad partikelärmerer Polybruch mit einem niedrigeren Metallpegel auf der Polyoberfläche erhalten. Der gereinigte Polysiliciumbruch war ohne Flecken auf dessen glänzenden Flächen.

### Beispiel 7: (Spülbad mit Ultraschall)

In einem Ultraschallbad wurde Polybruch für mehrere Minuten in eine Kunststoffwanne mit 18 MOhm Wasser eingebracht. Durch Anlegen von Ultraschall mit einem Arbeitsfrequenzbereich von 3 GHZ konnten Säurereste, die sich in einer rauen Polyoberfläche mit Rissen kleiner 5 µ nach dem Ätzen mit HF/HNO₃ befinden, entfernt werden. Als Vergleich wurde versucht, Säurereste am Polybruch in einem normalen Durchflussbecken mit 18 MOhm Wasser vollständig zu entfernen. Der Restsäuregehalt aus beiden Ansätzen wurde mit dem Ionenchromatographieverfahren, bzw. dem CE-Verfahren bestimmt.

| Rissiges Poly aus der normalen Spülung | | Rissiges Poly aus der Ultraschallspülung | |
|---|---|---|---|
| Fluorid | 2 pptw | Fluorid | < NWG ( 1 pptw ) |
| Nitrat | 5 pptw | Nitrat | < NWG ( 2 pptw ) |
| Nitrit | 0,1 pptw | Nitrit | < NWG ( 0,01 pptw ) |
| Chlorid | 3 pptw | Chlorid | < NWG ( 1 pptw ) |

### Beispiel 8: (Spülbäder mit 3 GHZ Ultraschall)

Ein Polysiliciumstab wurde mittels einer Vorrichtung aus einem Zerkleinerungswerkzeug und einer Siebvorrichtung zerkleinert und klassiert. 5 kg Polybruch wurden in einer Prozessschale mit folgendem Reinigungsprozess behandelt.

Zur Vorreinigung wurde der Polysiliciumbruch 20 Minuten in einer Mischung aus 5 Gew.-% HF, 8 Gew.-% HCl und 3 Gew.-% H₂O₂ bei einer Temperatur von 25°C gereinigt. Der Abtrag der Polysiliciumoberfläche betrug dabei 0,02 p.

Anschließend wurde für 5 Minuten mit 3 m³/Std in einem Ultraschallbad mit Kunststoffauskleidung bei 3 GHZ bei 22°C gespült. Bei der anschließenden Hauptreinigung wurde der Polysiliciumbruch 5 Minuten bei 8°C in einer Mischung von HF/HNO₃ mit 3 Gew.-% HF, 65 Gew.-% HNO₃ geätzt. Der Ätzabtrag betrug dabei ca. 12 µm.

Anschließend wurde für 5 Minuten mit 2 m³/Std in einem Ultraschallbad mit Kunststoffauskleidung bei 3 GHZ bei 22°C gespült. Der Polysiliciumbruch wurde anschließend in einem weiteren Schritt in einer Mischung aus HCl/H₂O₂ mit 8 Gew.-% HCl und 2 Gew.-% H₂O₂ für 5 Minuten bei 22°C hydrophiliert. Anschließend wurde für 5 Minuten mit 1 m³/Std bei 3 GHZ bei 22°C und bei 80°C weitere 5 Minuten mit 4 m³/Std in einem Ultraschallbad mit Kunststoffauskleidung gespült. Danach wurde für 60 Minuten mit Reinstluft der Klasse 100 bei 80°C getrocknet.

Ionenchromatographiemessungen oder CE-Messungen zeigen, dass der gereinigte Polybruch Säurereste unter der Nachweisgrenze enthält.

Folgende Metalloberflächenwerte wurden dabei erhalten:

| Element | Konzentration | | Element | Konzentration |
|---|---|---|---|---|
| Fe | 13 pptw | | Ti | 8 pptw |
| Cr | 1 pptw | | W | 1 pptw |
| Ni | 1 pptw | | K | 5 pptw |
| Na | 12 pptw | | Co | 0 pptw |
| Zn | 8 pptw | | Mn | 0 pptw |
| Al | 8 pptw | | Ca | 25 pptw |
| Cu | 2 pptw | | Mg | 8 pptw |
| Mo | 0 pptw | | V | 0 pptw |

### Vergleichsbeispiel 2: (Spülbäder mit 3 GHZ Ultraschall)

Es wurde analog dem Beispiel 8 vorgegangen, jedoch wurde bei den Spülschritten auf die Unterstützung von Ultraschall verzichtet.

Ionenchromatographiemessungen oder CE- Messungen zeigen, dass der gereinigte Polybruch noch Säurereste enthält.

Folgende Metalloberflächenwerte wurden dabei erhalten:

| Element | Konzentration | | Element | Konzentration |
|---|---|---|---|---|
| Fe | 13 pptw | | Ti | 23 pptw |
| Cr | 1 pptw | | W | 1 pptw |
| Ni | 1 pptw | | K | 5 pptw |
| Na | 24 pptw | | Co | 0 pptw |
| Zn | 8 pptw | | Mn | 0 pptw |
| Al | 28 pptw | | Ca | 45 pptw |
| Cu | 2 pptw | | Mg | 11 pptw |
| Mo | 0 pptw | | V | 0 pptw |

## Patentansprüche

1. Verfahren zur Reinigung von Polysiliciumbruch, **dadurch gekennzeichnet, dass** die Strömung der Reinigungsflüssigkeit in mindestens einem der Prozessschritte eine Strömungsgeschwindigkeit von größer 100 mm/sec aufweist, die aus mehr als zwei verschiedenen Richtungen auf die Oberfläche des Polysiliciumbruchs trifft.

2. Verfahren nach Anspruch 1, **dadurch gekennzeichnet, dass** die Reinigungsflüssigkeit durch nicht gerichtetes, diffuses Einblasen der Reinigungsflüssigkeit mittels Düsen auf die Oberfläche des Polysiliciumbruchs trifft.

3. Verfahren nach Anspruch 1, **dadurch gekennzeichnet, dass** die Reinigungsflüssigkeit über einen oder mehrere bewegte Düsenkränze im Ätzbecken auf die Oberfläche des Polysiliciumbruchs trifft.

4. Verfahren nach Anspruch 1, **dadurch gekennzeichnet, dass** die Reinigungsflüssigkeit durch die Anordnung der Düsen im Ätzbecken in eine Rotationsbewegung versetzt wird.

5. Verfahren nach Anspruch 1, **dadurch gekennzeichnet, dass** der Polysiliciumbruch in einer Vorrichtung innerhalb der Reinigungsflüssigkeit in horizontaler oder vertikaler Richtung rotiert.

6. Verfahren nach Anspruch 1, **dadurch gekennzeichnet, dass** die Reinigungsflüssigkeit durch zusätzliches, nicht gerichtetes Einblasen von Luft mittels Düsen in eine Strömung versetzt wird.

7. Verfahren nach Anspruch 1, **dadurch gekennzeichnet, dass** die Strömungsgeschwindigkeiten und Strömungsrichtungen durch den Einsatz von Ultraschall erzeugt werden.

8. Verfahren nach Anspruch 1 bis 6, **dadurch gekennzeichnet, dass** der Siliciumbruch zusätzlich in einer Hub-Senkbewegung im Ätzbecken bewegt wird.

9. Verfahren nach Anspruch 7, **dadurch gekennzeichnet, dass** der Siliciumbruch bei den Hub-/Senkbewegungen ganz oder teilweise aus der Reinigungslösung entnommen wird.

## Claims

1. Method for cleaning polysilicon fragments, **characterized in that** the flow of the cleaning liquid in at least one of the process steps has a flow velocity of greater than 100 mm/sec, which impinges on the surface of the polysilicon fragments from more than two different directions.

2. Method according to Claim 1, **characterized in that** the cleaning liquid impinges on the surface of the polysilicon fragments by non-directional, diffuse injection of the cleaning liquid by means of nozzles.

3. Method according to Claim 1, **characterized in that** the cleaning liquid impinges on the surface of the polysilicon fragments via one or more moved nozzle rings in the etching tank.

4. Method according to Claim 1, **characterized in that** the cleaning liquid is caused to effect rotational movement by virtue of the arrangement of the nozzles in the etching tank.

5. Method according to Claim 1, **characterized in that** the polysilicon fragments rotate in a horizontal or vertical direction in a device within the cleaning liquid.

6. Method according to Claim 1, **characterized in that** the cleaning liquid is caused to effect a flow by additional, non-directional injection of air by means of nozzles.

7. Method according to Claim 1, **characterized in that** the flow velocities and flow directions are produced by the use of ultrasound.

8. Method according to Claims 1 to 6, **characterized in that** the silicon fragments are additionally moved in a lifting/lowering movement in the etching tank.

9. Method according to Claim 7, **characterized in that** the silicon fragments are wholly or partly removed from the cleaning solution during the lifting/lowering movements.

## Revendications

1. Procédé de purification de fragments de polysilicium, **caractérisé en ce que** l'écoulement du liquide de purification, qui arrive à partir de plus de deux directions différentes sur la surface des fragments de polysilicium, présente lors d'au moins une des étapes du procédé une vitesse d'écoulement supérieure à 100 mm/s.

2. Procédé selon la revendication 1, **caractérisé en ce que** le liquide de purification arrive sur la surface des fragments de polysilicium par une injection diffuse non dirigée du liquide de purification au moyen de buses.

3. Procédé selon la revendication 1, **caractérisé en ce que** le liquide de purification arrive sur la surface des fragments de polysilicium par une ou plusieurs couronnes de buses agitées dans le bassin de corrosion.

4. Procédé selon la revendication 1, **caractérisé en ce que** le liquide de purification est déplacé en un mouvement de rotation par l'agencement des buses dans le bassin de corrosion.

5. Procédé selon la revendication 1, **caractérisé en ce que** les fragments de polysilicium sont mis en rotation dans un dispositif dans le liquide de purification dans une direction horizontale ou verticale.

6. Procédé selon la revendication 1, **caractérisé en ce que** le liquide de purification est déplacé en écoulement par une injection supplémentaire non dirigée d'air au moyen de buses.

7. Procédé selon la revendication 1, **caractérisé en ce que** les vitesses d'écoulement et les directions d'écoulement sont générées par l'utilisation d'ultrasons.

8. Procédé selon les revendications 1 à 6, **caractérisé en ce que** les fragments de silicium sont également déplacés selon un mouvement de soulèvement et d'abaissement dans le bassin de corrosion.

9. Procédé selon la revendication 7, **caractérisé en ce que** les fragments de silicium sont extraits en totalité ou en partie de la solution de purification lors des mouvements de soulèvement et d'abaissement.
